# EUROPÄISCHE PATENTSCHRIFT

(11) **EP 1 320 133 B1**
(45) Veröffentlichungstag und Bekanntmachung des Hinweises auf die Patenterteilung: **30.06.2004**
(21) Anmeldenummer: 03006424.0
(22) Anmeldetag: 22.10.1997
(51) Int. Cl.: H01L 29/739

(54) **IGBT mit Trench-Gate-Struktur**
Trench gate IGBT
IGBT avec grille dans une tranchée

(30) Priorität: 06.12.1996 DE 19650599; 12.02.1997 DE 19705276
(43) Veröffentlichungstag der Anmeldung: 18.06.2003
(62) Teilanmeldung aus: 97118304.1
(73) Patentinhaber: SEMIKRON Elektronik GmbH, 90431 Nürnberg (DE)
(72) Erfinder: Herzer, Reinhard, Dr., 98693 Ilmenau (DE); Netzel, Mario, Dr., 98693 Ilmenau (DE)

(56) Entgegenhaltungen:
- DE-A- 4 324 481
- US-A- 5 329 142
- PATENT ABSTRACTS OF JAPAN vol. 1996, no. 09, 30. September 1996 (1996-09-30) -& JP 08 116056 A (HITACHI LTD), 7. Mai 1996 (1996-05-07)

## Beschreibung

Die Erfindung beschreibt einen IGBT (Insulated-Gate-Bipolar-Transistors) mit einer Gräben-Gate-Struktur (auch Trench-Gate-Struktur genannt).

Nach dem Stand der Technik sind IGBT mit Trench-Gate-Struktur in jüngster Zeit bekannt geworden. Trenchstrukturen an sich werden in großem Umfang für die Herstellung von Speicherzellen für hochintegrierte Speicherschaltkreise verwendet. Bekannt sind auch Leistungshalbleiterbauelemente mit Trenchstrukturen, insbesondere werden sie zur Realisierung des Gatekomplexes seit einiger Zeit eingesetzt. Hier seien beispielhaft vertikale DMOS-Transistoren (doppelt-diffundierte MOS-Transistoren) für den unteren Spannungsbereich (<100V) genannt.

Für diese Trench-MOS-Transistoren werden schmale Trenchgräben mit geringen vertikalen Tiefen verwendet, z.B. ca. 1,5µm Tiefe und ca. 1,5µm Breite für 50V-MOSFET. Dabei wird eine hohe Dichte dieser Trenchstrukturen angestrebt, um eine hohe Kanalweite pro Flächeneinheit zur erreichen. Die Herstellung des Trench-Gate-Komplexes für diese Trench-MOS-Transistoren entspricht dem Stand der Technik nach EP 0698 919 A2. Der fachliche Hintergrund der Trenchtechnologie soll zunächst an einem Beispiel einer Anwendung näher erläutert werden, da Trench-Gate-Strukturen auch bereits für IGBT vorgeschlagen und verwendet wurden (IEDM, Techn. Digest., S. 674-677, 1987).

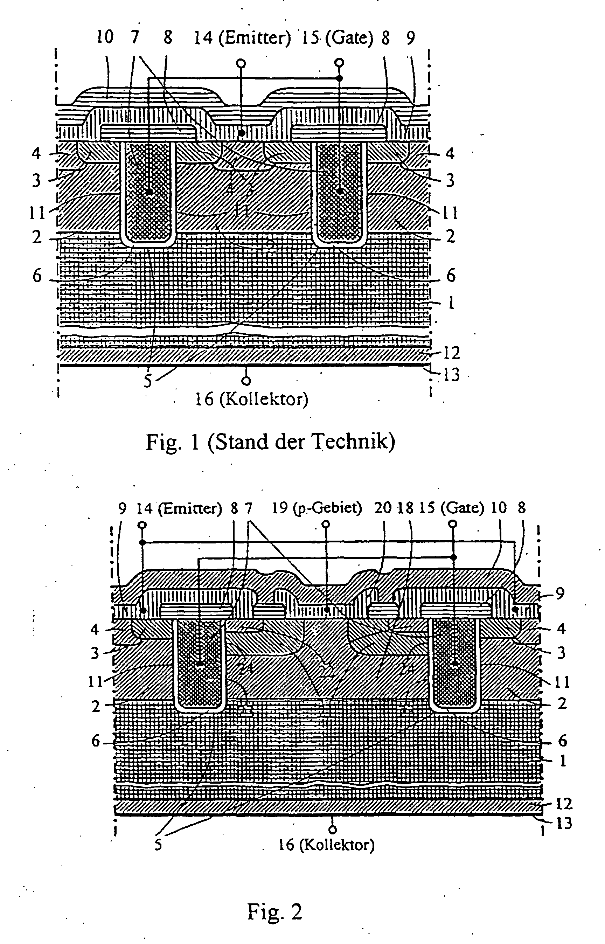

Fig. 1 zeigt eine derartige Anordnung nach dem Stand der Technik in nicht maßstabsgerechtem Querschnitt einer Zelle als Skizze. Zunächst unterscheidet man prinzipiell erstens zwischen einem Nonpunchthrough-IGBT-Aufbau, gekennzeichnet durch ein dickes n⁻-Substrat (1) und einem dünnen, rückseitig implantierten p-Emitter (12) als Kollektor des Gesamtbauelementes, wie das in Fig. 1 dargestellt ist. Eine zweite nicht dargestellte Variante wird gebildet durch einen Punchthrough-IGBT-Aufbau, die durch ein p⁺-Substrat gekennzeichnet ist, auf dem eine erste n-dotierte Zwischenschicht und eine zweite niedrig dotierte epitaktisch abgeschiedene n⁻-Schicht aufgebracht wurden.

Die Zellstruktur an der Waferoberseite ist für beide Typen gleich. Sie besteht aus einem p-Bulkgebiet (2), den n⁺-Sourcegebieten (3) und den p⁺-Bulk-Anschtußgebieten (4), welche durch streifen- oder gitterförmig angeordnete vertikale Ätzgräben oder Trenches (5) unterbrochen werden. Diese Trenchstrukturen (5) sind allseitig zum Silizium hin mit einem Gateisolator (6) versehen, mit Polysilizium (7) verfüllt und nach oben zum Aluminium (9) hin mit einer Passivierungsschicht (8) abgedeckt.

Polysilizium (7), Gateisolator (6) und p-Gebiet (2) bilden einen MOS-Kondensator des internen MOSFET, dessen Kanal (11) zwischen dem n⁺-Sourcegebiet (3) und dem n⁻-Substrat (1) vertikal an der Seitenwand des Trenches entsteht. Die streifen- oder gitterförmig angeordneten Trench-Gate-Strukturen sind untereinander in z-Richtung zu einem gemeinsamen Gateanschluß (15) verbunden.

Die n⁺-Sourcegebiete (3) sowie die p⁺-Anschlußgebiete (4) aller so gebildeten Zellen werden über eine Aluminiummetallisierung (9) miteinander verbunden. Die Metallisierung stellt den Emitteranschluß (14) des IGBT dar. Die gesamte Struktur ist mit Ausnahme der Bondflächen mit einer Passivierungsschicht (10) abgedeckt. Der Kollektor (16) des IGBT wird durch eine weitere Metallisierung (13) an der Waferrückseite gebildet.

Der Stand der Technik beinhaltet auch die Anwendung von multiplen Trenches für abschaltbare Thyristoren in MOS-Technologie sowie für Hochspannungs-IGBT's. Zellen mit multiplen Trenches werden in der JP 08 116 056 A sowie in "Mitsuhiko Kitagawa et.al.: "A 4500V Injection Enhanced Insulated Gate Bipolar Transistor..." in IEDM (1993), S. 679 - 682" beschrieben. Der Strukturaufbau des dort vorgestellten IEGT's (Injektion Enhancend Insulated Gate Bipolar Transistor) entspricht einer Kombination eines herkömmlichen IGBTs und Zellen mit multiplen Trenches. Die Zelle eines IEGTs enthält mehrere Trenches, wobei nur an den zum Zelläußeren gewandten Flanken der am Zelläußeren liegenden Trenches eine MOS-Struktur ausgebildet wird. Zwischen den übrigen Trenches befindet sich ein p-Gebiet. Der Abstand aller Trenches in der Zelle ist gleich (äquidistante Anordnung der Trenches).
In US 5,329,142 wird das Zellkonzept mit multiplen Trenches auf weitere Strukturen der Leistungselektronik angewendet. So werden MOS-gesteuerte Thyristoren und MOS-gesteuerte Lateralstrukturen beschrieben. Im dortigen Hauptanspruch, den Fig. 69, 71, 72, 74 und 75 und in den dazugehörenden Beschreibungstexten ist exakt und ausführlich die MOS-Thyristorstruktur dargestellt. Das dortige p⁺-Gebiet (28) ist mit der Kathode (34) und das p⁻-Gebiet (18) ist nicht mit der Kathode (34) verbunden, damit ergibt sich eine (abschaltbare) MOS-Thyristorstruktur. Durch diese Konstruktion entstehen zwei schaltbare Zustände. Einerseits entsteht ein vertikaler n-Kanaltransistor, gebildet aus dem n⁻-Gebiet (12), dem p⁻-Gebiet (18), dem n⁻-Gebiet (26) und dem Trench-Gate, über welches der n-Kanal MOSFET bei positiver Gatesparnnung eingeschaltet wird (turn on-Transistor des Thyristors).
Andererseits entsteht ein vertikaler p-Kanal-Transistor, gebildet aus dem p⁻-Gebiet (18), dem n⁻-Gebiet (26), dem p⁺-Gebiet (28) und dem Trench-Gate, über welches der p-Kanal MOSFET bei negativer Gatespannung eingeschaltet wird (turn off-Transistor des Thyristors).

Mit multiplen Trenchstrükturen, wie sie für die MOS-Thyristoren und Hochspannungs-IGBTs zur Erzielung kleiner Flußspannungen zum Einsatz kommen, wird eine massive Steigerung der Elektroneninjektionswirkung erzielt.
Durch die großen Gateflächen erhöht sich die Millerkapazität allerdings beträchtlich, was zu hohen Schaltverlusten führt. In Schaltungen mit Thyristoren stört diese Tatsache bisher wenig, da mit kleinen Betriebsfrequenzen gearbeitet wird, der Vorteil der minimalen Flußspannungen besitzt hier die Priorität.

Weitere Problemlösungen mit ähnlichem Inhalt sind in
- US 5,448,083
- Mitsuhiko Kitawa et.al.:" 4500V IEGTs having.Switching Characteristics Superior go GTO" in Proceedings of 1995 International Symposium on Power Semicondauctor Devices & Ics, Yokahama, S. 486 - 490
erläutert. Andere Problemlösungen, wie in DE 43 24 481 A1 betreffen nur die Randstrukturen von IGBT's.

Von Mitsubishi (Proc. ISPSD'94, S. 411-416, Davos, 1994) wurden, abgeleitet von den Trench-MOSFET-Strukturen, Trenchgates mit einer Tiefe von ca. 3µm und einer Breite von ca. 1µm für 600V-IGBT vorgestellt. Der Abstand der streifenförmigen Trenches wurde zwischen 3,5µm und 14µm variiert. Für kleine Abstände erhält man für diesen Trench-IGBT (TIGBT) ebenfalls eine hohe Dichte der Trenchstrukturen.
TIGBT dieser Art erreichen gegenüber IGBT mit planarem Gate eine deutlich reduzierte Flußspannung. Diese Verringerung wird insbesondere durch den geringen Kanalwiderstand aufgrund der hohen Kanalweite pro Flächeneinheit erreicht. Nachteilig ist jedoch, daß aufgrund der hohen Kanalweite das Sättigungsstromniveau gegenüber IGBT mit planarem Gate um ein Mehrfaches erhöht ist. Dadurch verkürzt sich die Zeitspanne erheblich, in der das Bauelement einen Kurzschluß ohne Zerstörung überstehen kann.
In EP 0 756 330 werden ebenfalls schmale Trenches für verschiedene Zellen angewendet. Weiterhin werden Verfahren zur Herstellung von Leistungshalbleitern mit derartigen Zellen vorgestellt. Ein Teil der Zellen aus EP 0 756 330 sind mit multiplen Trenches ausgeführt. Auch hier ist das gemeinsames Kennzeichen aller Zellen eine äquidistante Anordnung der Trenches.

Für die erfinderische Aufgabenlösung waren die IGBT-Strukturen, wie sie bisher nach dem Stand der Technik vorgestellt wurden, nicht verwendbar, denn es werden gleichzeitig eine geringe Flußspannungen und niedrige Schaltverluste gefordert um auch bei höheren Betriebsfrequenz niedrige Gesamtverluste zu erhalten.

Die vorliegende Erfindung hat sich die Aufgabe gestellt, ein Leistungshalbleiterbauelement in der Form eines Trench-Gate-IGBT darzustellen, das neben hohen Sperrspannungen und geringen Durchlaßverlusten auch geringe Schaltverluste aufweist.

Die Aufgabe wird bei Leistungshalbleiterbauelementen mit IGBT-Trench-Gate-Struktur der dargestellten Art durch die Maßnahmen des Anspruches 1 gelöst, bevorzugte Weiterbildungen werden in den Unteransprüchen dargestellt.

Die Erfindung wird nachfolgend durch die Beschreibung des Trench-Gate-Komplexes dargestellt. Dabei wird ein IGBT mit einem n-Kanal zugrunde gelegt. In analoger Weise gelten die Darstellungen und Beschreibungen auch für IGBT mit einem p-Kanal, die dotierten Gebiete in den Abbildungen 1 - 9 haben dann die entgegengesetzte Leitfähigkeit.

Die wesentliche erfinderische Idee besteht darin, an bestimmten Stellen innerhalb der Zellmatrix anstelle der MOS- Struktur des IGBT nur ein p-Gebiet auszubilden und in dieses Bauelementen und Schaltungen zu integrieren, die z.B. ein schnelleres Ein- oder Ausschalten des Trench-IGBT ermöglichen.

Die erfinderischen Gedanken werden auf der Grundlage der Fig. 1 bis 9 erläutert:
Fig. 1 zeigt eine bereits beschriebene Anordnung nach dem Stand der Technik.
Fig. 2 stellt in Skizze die erfinderische Integration von Bauelementen im p-Gebiet dar.
Fig. 3 zeigt eine mögliche Beschaltung der IGBT-Struktur nach Fig. 2.
Fig. 4 skizziert eine andere erfinderische Variante der Trench-Struktur mit integriertem Einschaltwiderstand (Rₚ).
Fig. 5 zeigt eine Draufsicht einer IGBT-Struktur mit streifenförmigem Design nach Fig. 1.
Fig. 6 stellt eine weitere Variante nach Fig. 5 dar.
Fig. 7 stellt die Inselstruktur der Trench-Gate-Zellen dar.
Fig. 8 zeigt eine mögliche Variante für die elektrische Verbindung der Struktur nach Fig. 7.
Fig. 9 zeigt die Draufsicht der Trench-Gate-Struktur nach Fig. 4 bei zellförmigem Design.

Fig. 2 zeigt den zu Fig. 1 analogen Ausschnitt einer IGBT-Zellstruktur, in der eine beispielhafte Variante der erfinderischen Idee umgesetzt ist. Die Trenchstrukturen (5) sind allseitig zum Silizium hin mit einem Gateisolator (6) versehen, vollständig mit Polysilizium (7) verfüllt und nach oben zum Aluminium (9) hin mit einer Passivierungsschicht (8) abgedeckt. Zwischen den streifen- oder gitterförmig angeordneten Trench-Gate-Strukturen sind im Wechsel einerseits die p-Bulkgebiete (2), die n⁺-Emittergebiete (3) und die p⁺-Bulk-Anschlußgebiete (4) sowie andererseits das p-Gebiet (18) angeordnet. Das p-Gebiet (18) kann wiederum eine geringere oder vergleichbare Eindringtiefe wie das p-Bulkgebiet (2) aufweisen. Auch kann die Eindringtiefe so gewählt werden, daß die inneren Trenchecken der Struktur umschlossen werden.

Im p-Gebiet (18) selbst ist an den Seiten der begrenzenden Trenchstruktur jeweils ein vertikaler pMOS-Transistor angeordnet, der durch die p⁺-Draingebiete (22), die n-Wanne (21, Bulk) und das p-Gebiet (18, Source) selbst gebildet wird. Gesteuert wird der pMOS-Transistor über die Gatestruktur des Trenches (5), bestehend aus dem Gateisolator (6) und dem Polysilizium-Gate (7).

Das p⁺-Draingebiet (22) des pMOS-Transistors ist über die Metallisierung (9) mit dem Emitter (14) kurzgeschlossen. p-Sourcegebiet (18) und n-Bulkgebiet (21) des pMOS-Transistors sind dagegen über die Metallisierung (20) kurzgeschlossen, die als Anschluß (19) nach außen geführt wird. Dieser Anschluß kann floatend betrieben werden oder an ein äußeres Potential direkt oder über weitere Elemente angeschlossen werden. Weitere Elemente können ein fester Widerstand, ein gesteuerter Widerstand oder eine externe oder integrierte Schaltung sein.

Durch die Integration des pMOS-Transistors entsteht außerdem ein parasitärer nMOS-Transistor, bestehend aus n-Wannengebiet (21) als Source, dem p-Gebiet (18) als Bulk und dem n--Substratgebiet (1) als Drain. Gesteuert wird der nMOS-Transistor über die Gatestruktur des Trenches (5).

Prinzipiell ist es auch möglich, das n-Bulkgebiet (21) nicht mit dem p-Gebiet (18) elektrisch zu verbinden und es floatend zu betreiben. Bei dieser Variante kann der parasitäre nMOS-Transistor keinen Strom führen (Source nicht angeschlossen). Nachteilig ist hierbei zu nennen, daß parasitäre Bipolar- bzw. Thyristorstrukturen gegeben wären.

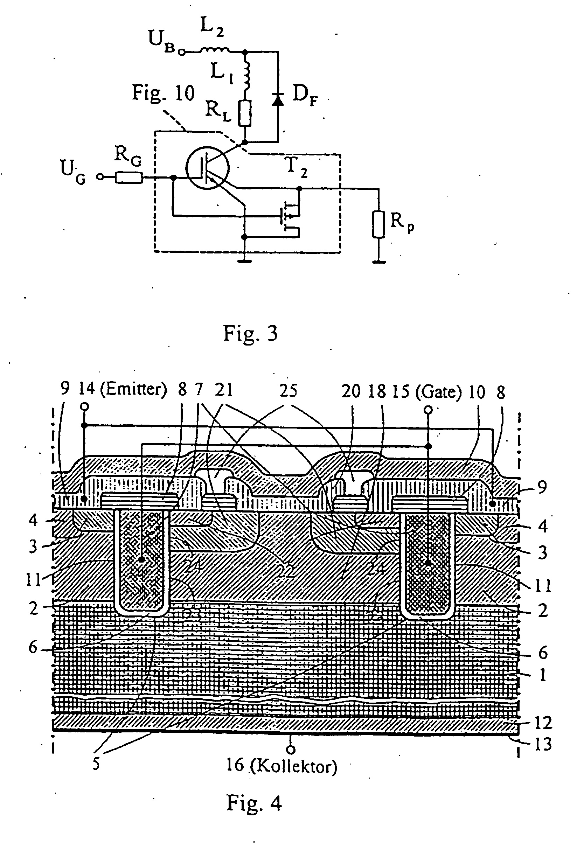

Fig. 3 zeigt eine mögliche Beschaltung der IGBT-Struktur nach Fig. 2, wobei zwischen dem Anschlüß des p-Gebietes (19) und dem Emitter (14) ein fester Widerstand Rp geschaltet ist. Weitere übliche Elemente der äußeren Beschaltung sind die Freilaufdiode DF, die Streuinduktivität L2 und die Last, bestehend aus L1 und RL.

Der Widerstandswert für Rp ist dabei so zu wählen, daß sich minimale Einschaltverluste und eine geringe Flußspannung ergeben. Ein Widerstandswert in bestimmter Höhe ist auch erforderlich, damit der parasitäre nMOS-Transistor durch Source-Gegenkopplung keinen nennenswerten Strom führen kann und dadurch die elektrischen Eigenschaften der Gesamtstruktur nicht nachteilig verändert werden.

Durch die Anordnung des pMOS-Transistors als parallel geschaltete Wiederholstruktur wird eine große Kanalweite und damit ein niedriger Einschaltwiderstand für den pMOS-Transistor erreicht. Eindringtiefe und Dotierung des p-Gebietes (18) und der n-Wanne (21) sind so zu wählen und aufeinander abzustimmen, daß die Punchthrough-Reserve im p-Gebiet und damit die Sperrfähigkeit des Gesamtbauelementes gewährleistet ist und die Schwellspannung des pMOS-Transistors bei negativen Spannungen liegt (beispielhaft - 3V).

Bei positiver Spannung am Polysilizium-Gate (7), z.B. +15 Volt gegenüber Emitter (14), ist der vertikate n-Kanal (11) an der einen Seite des Trenches (5) ausgebildet und der IGBT eingeschaltet während der vertikale p-Kanal (24) des pMOS-Transistors auf der anderen Seite des Trenches (5) sperrt. Bei negativer-Spannung am Polysilizium-Gate (7), z.B. -15 Volt gegenüber Emitter (14), ist der vertikale n-Kanal (11) und damit der IGBT gesperrt während der vertikale p-Kanal (24) ausgebildet und der pMOS-Transistor eingeschaltet ist.

In diesem Fall kann ein Löcherstrom aus dem n--Gebiet (1) des IGBT über die p-Anreicherungsschicht (23) und den p-Kanal (24) zum p+-Drain (22) des pMOS-Transistors fließen, der wiederum über die Metallisierung (9) mit dem Emitter (14) verbunden ist. Der Widerstand Rp parallel zum pMOS-Transistor trägt in diesem Fall aufgrund des höheren Widerstandswertes kaum zum Stromfluß bei.

Mit der vorgestellten Struktur in Fig. 2 und ihrer Beschaltung entsprechend Fig. 3 wird der Widerstand zwischen p-Gebiet (18) und Emitter (14) automatisch über die Trench-Gate-Spannung so gesteuert, daß während des Einschaltens des IGBT der hochohmige Widerstand Rp wirkt (pM0S-Transistor aus) und während des Ausschaltens des IGBT der niederohmige pMOS-Transistor leitend wird, was das Ausräumen der Löcher aus dem n--Gebiet (1) beschleunigt. Damit werden die Schaltverluste vorteilhaft beeinflußt.

Fig. 4 stellt eine weitere IGBT-Trench-Gate-Struktur vor, bei der auch der Widerstand Rp in den Halbleiterkörper integriert wird, wodurch ein zusätzlicher IGBT-Anschluß und die externe Widerstandsbeschaltung mit Rp entfällt. Realisiert wird dies durch ein entsprechendes hochohmiges Widerstanüsgebiet (25), das beispielhaft aus Polysilizium gebildet wird und zwischen der Metallisierung (20) des p-Gebietes (18) und der Metallisierung (9) des Emitters (14) positioniert ist. Der skizzierte Ausschnitt der IGBT-Zellstruktur und die übrigen dargestellten Gebiete sind identisch zu Fig. 2.

Die integrierten Strukturen in Fig. 2 und 4 dienen der Verbesserung der dynamischen Parameter der IGBTs. Durch die mit den eingebrachten Dotierungsgebieten (21, 22) entstehenden Bauelemente können jedoch auch komplexere Schaltungsanordnungen ausgebildet werden, die z.B. für die Ansteuerung und Überwachung des IGBTs verwendet werden können.

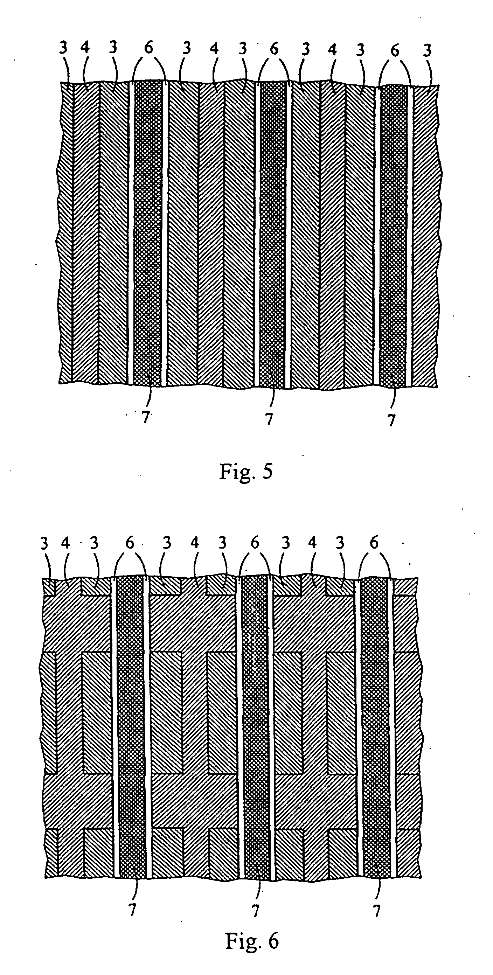

Fig. 5 zeigt eine Draufsicht einer IGBT-Struktur mit streifenförmigem Design nach Fig. 1. Die Bezeichnung der einzelnen Elemente ist dabei beibehalten worden. Fig.5 stellt eine reine Streifenstruktur dar. Dargestellt ist die Struktur im Silizium (ohne Deckschichten) mit streifenförmiger Polysiliziumzone (7), an der beidseitig, also an beiden Flanken die Gateoxidschicht (6) und die n⁺-Source-Gebiete (3) ausgebildet sind. Zwischen den n⁺-Source-Gebieten (3) sind die p⁺-Bulk-Arischlußgebiete (4) angeordnet.

Fig. 6 stellt eine weitere Variante nach Fig. 5 dar. Die Streifenstruktur des Polysiliziums (7) ist in gleicher Weise ausgebildet. Die n⁺-Source-Gebiete (3) sind dagegen unterbrochen ausgebildet. Dadurch liegen einerseits n⁺-Source-Gebiete (3) und andererseits p⁺-Bulk-Anschlußgebiete (4) unmittelbar an der Oxidschicht der Gateisolation (6).

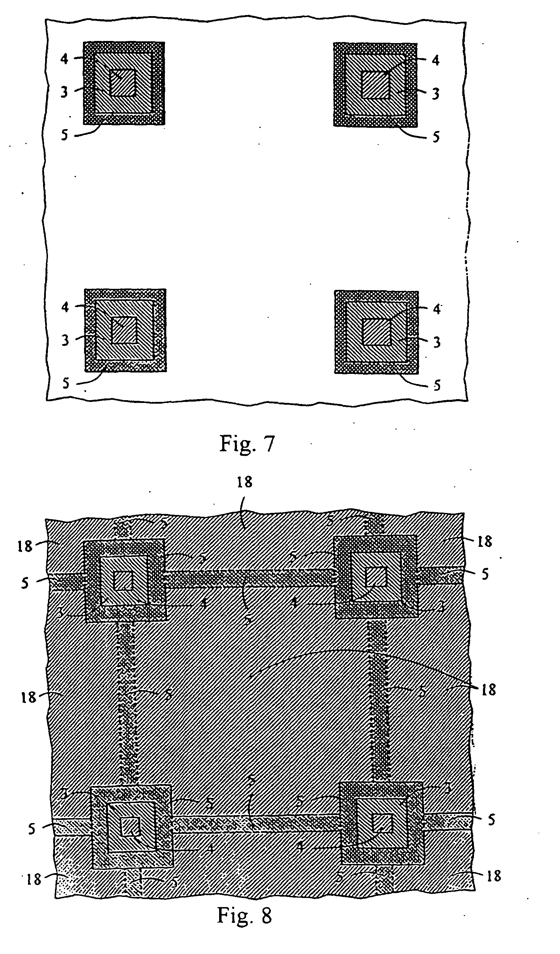

Fig. 7 stellt die Inselstruktur der Trench-Gate-Zellen dar. Die einzelnen Trench-Gate-Zellen sind voneinander räumlich und elektrisch getrennt. Gezeichnet ist ein Design-Ausschnitt mit vier einzelnen Zellen. Sie bestehen dem Prinzip nach aus dem p⁺-Bulk-Anschlußgebiet (4), n⁺-Source-Gebiet (3) und dem Trench (5). Die einzelnen Trenches sind voneinander isoliert. Die Zwischenräume zwischen den Trench-Gate-Zellen sind alternativ Isolatorgebiete (17), Dotierungsgebiete (18) des zweiten Leitungstyps oder Substratgebiete (1) des ersten Leitungstyps.

Fig. 8 zeigt eine mögliche Variante der elektrischen Verbindung nach Fig. 7. Die Verbindung mit Trench-Gebieten (5 - gestrichelt) mittels vergrabener Gebiete ist technologisch in dem gleichen Verfahrensschritt bei der Herstellung der Trenches möglich.

Die Lösung bietet in dem Halbleitervolumen den Platz für die beispielhaft . ausgeführte Trenchstruktur. In den Trench-Gräben (5 - gestrichelt) lassen sich technologisch Polysilizium-Leitbahnen zur elektrischen Kontaktierung der Trenches untereinander einbringen. Das Gateoxid (6) im Trench (5) und die Passivierung (8) isolieren die vergrabenen Leitbahnen vollständig. Bei sonst beliebigen Zellstrukturen (z.B. Quadrate, Rechtecke oder Sechsecke) können die elektrischen Verbindungen ausgeführt werden.

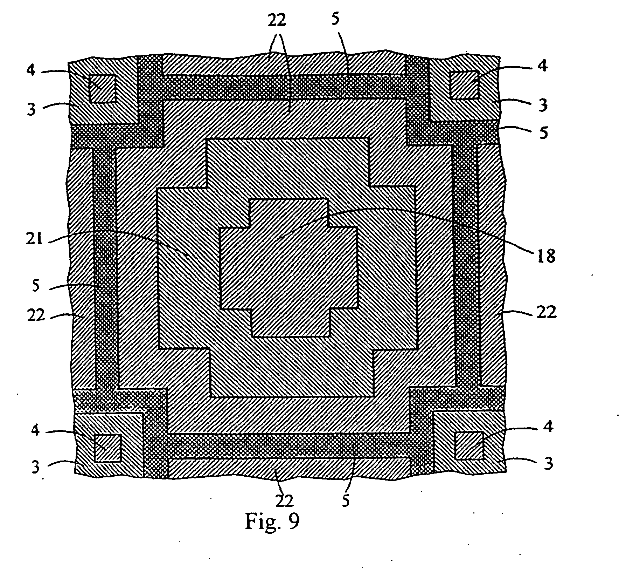

Fig. 9 zeigt die Draufsicht der Trench-Gate-Struktur nach Fig. 4 bei zellförmigem Design. Diese Struktur beinhaltet in seinem p-Gebiet (18 Source) die n-Wanne (21, Bulk), in dieser wiederum das p+-Draingebiet (22). Die weiteren Zeichnungselemente wurden bereits vorgestellt.

Alternativ lassen sich die Verbindungen zwischen den räumlich und elektrisch getrennten Trench-Gate-Strukturen auch über Metall- oder Polysilizium-Leitbahnen auf der Siliziumoberfläche realisieren.

## Patentansprüche

1. Trench-Gate-IGBT (Insulated Gate Bipolar Transistor), mit mindestens zwei aneinander grenzenden gleichartigen Zellen, mit einem Substratgebiet des ersten Leitungstyps (1), mit einem Rückseitenemitter vom zweiten Leitungstyp (12), mit streifen-, insel- oder gitterförmigen angeordneten Trenchstrukturen (5), die allseitig zum Substratgebiet hin mit einem Gateisolator (6) versehen, mit Polysilizium (7) verfüllt und mit einer Passivierungsschicht (8) abgedeckt sind, mit einer vertikalen MOS-Struktur, welche an der einen vertikalen Flanke der Trenchstrukturen angeordnet ist und aus einem Bulkgebiet (2) des zweiten Leitungstyps, dessen mit einer Emitterelektrode (9) verbundenen Anschlußgebiet (4) vom zweiten Leitungstyp, sowie einem innerhalb des Bulkgebietes (2) liegenden ebenfalls mit der Emitterelektrode (9) verbundenen Source- bzw. Emittergebiet (3) vom ersten Leitungstyp besteht und mit einem an der jeweils anderen Flanke der Trenchstrukturen angeordneten Dotierungsgebiet (18) vom zweiten Leitungstyp
wobei
im Dotierungsgebiet (18) vom zweiten Leitungstyp an der vertikalen Flanke Wannengebiete vom ersten Leitungstyp (21) eingebracht sind, in welchen sich wiederum Dotierungebiete (22) vom zweiten Leitungstyp befinden, wobei über mindestens ein Metallisierungsgebiet (20), welches mit der Emitterelektrode (9) keine Verbindung oder nur eine Verbindung mittels einer Widerstandsschicht aufweist, das Dotierungsgebiet (18) mit dem Wannengebiet (21) verbunden ist.

2. Trench-Gate-IGBT nach Anspruch 1, wobei
die Wannengebiete (21) und Dotierungsgebiete (22) zusammen mit dem Dotierungsgebiet (18) vom zweiten Leitungstyp und dem Substratgebiet (1) sowie der Trench- Gatestruktur (5) und der Metallisierung (20) pMOSFET, nMOSFET, Bipolartransistoren und / oder integrierte Schaltungen bilden.

3. Trench-Gate-IGBT nach Anspruch 1, wobei
das zwischen den Trenchstrukturen liegende Dotierungsgebiet (18) vom zweiten Leitungstyp floatend ist oder Über die Metallisierung (20) mit einer äußeren Beschaltung Kontaktiert wird.

4. Trench-Gate-IGBT nach Anspruch 1, wobei
räumlich und elektrisch isolierte Trench-Gate-Zellen ausgebildet werden, die zusätzliche Trench-Gate-Strukturen oder Metall- oder Polysilizium-Leitbahnen zur elektrischen Verbindung aufweisen.

## Claims

1. A trench-gate IGBT (insulated gate bipolar transistor), having at least two adjoining identical cells, having a substrate region of the first line type (1), having a rear emitter of the second line type (12), having trench structures (5) positioned as strips, islands, or lattices, which are provided on all sides toward the substrate region with a gate insulator (6), are filled with polysilicon (7), and covered with a passivation layer (8), having a vertical MOS structure, which is positioned on one vertical flank of the trench structures and comprises a bulk region (2) of the second line type, its terminal region (4) of the second line type, which is connected to an emitter electrode (9), as well as a source and/or emitter region (3) of the first line type, which is inside the bulk region (2) and is also connected to the emitter electrode (9), and having a doping region (18) of the second line type, positioned on the particular other flank of the trench structures,
wherein trough regions of the first line type (21), in which doping regions (22) of the second line type are located in turn, are introduced into the doping region (18) of the second line type on the vertical flank, the doping region (18) being connected to the trough region (21) via at least one metallization region (20), which has no connection to the emitter electrode (9) or only one connection using a resistor layer.

2. The trench gate IGBT according to Claim 1,
wherein the trough regions (21) and doping regions (22), together with the doping region (18) of the second line type and the substrate region (1), as well as the trench-gate structure (5) and the metallization (20), form pMOSFET, nMOSFET, bipolar transistors, and/or integrated circuits.

3. The trench gate IGBT according to Claim 1,
wherein the doping region (18) of the second line type lying between the trench structures is floating or is in contact with an external circuit via the metallization (20).

4. The trench gate IGBT BT according to Claim 1,
wherein spatially and electrically insulated trench-gate cells are implemented which have additional trench-gate structures or metal or polysilicon printed conductors for the electrical connection.

## Revendications

1. Transistor bipolaire à grille isolée (IGBT, pour Insulated Gate Bipolar Transistor) dont la grille est dans une tranchée et qui comporte au moins deux cellules analogues contiguës ; une zone de substrat de première type de conductivité (1), un émetteur arrière de deuxième type de conductivité (12), des structures en tranchée (5) disposées sous forme de bandes, d'îlots ou de réseau, lesquelles sont pourvues d'un diélectrique de grille (6) de tous les côtés dirigés vers la zone de substrat, lesquelles sont remplies de silicium polycristallin (7) et lesquelles sont recouvertes d'une couche de passivation (8), une structure MOS verticale qui est disposée sur l'un des flancs verticaux des structures en tranchée et qui est constituée d'une zone massive (2) de deuxième type de conductivité, comportant une zone de raccordement (4) de deuxième type de conductivité reliée à une électrode d'émetteur (9), ainsi que d'une zone de source ou d'émetteur (3) de premier type de conductivité située à l'intérieur de la zone massive (2), et une zone de dopage (18) de deuxième type de conductivité disposée sur l'autre flanc des structures en tranchée et également reliée à l'électrode d'émetteur (9),
dans lequel
des zones en forme de cuvette de premier type de conductivité (21) sont mises en place dans la zone de dopage (18) de deuxième type de conductivité sur le flanc vertical, zones en forme de cuvette dans lesquelles se trouvent à leur tour des zones de dopage (22) de deuxième type de conductivité, la zone de dopage (18) étant reliée à la zone en forme de cuvette (21) par l'intermédiaire d'au moins une zone de métallisation (20) qui ne comporte aucune connexion, ou une seule connexion, avec l'électrode d'émetteur (9) au moyen d'une couche résistive.

2. Transistor bipolaire à grille isolée dans une tranchée selon la revendication 1, dans lequel les zones en forme de cuvette (21) et les zones de dopage (22) forment conjointement avec la zone de dopage (18) de deuxième type de conductivité et avec la zone de substrat (1), ainsi qu'avec la structure à grille dans une tranchée (5) et la métallisation (20), des transistors bipolaires à effet de champ pMOS, à effet de champ nMOS et/ou des circuits intégrés.

3. Transistor bipolaire à grille isolée dans une tranchée selon la revendication 1, dans lequel la zone de dopage (18) de deuxième type de conductivité située entre les structures en tranchée est flottante ou est mise en contact avec un branchement extérieur par l'intermédiaire de la métallisation (20).

4. Transistor bipolaire à grille isolée dans une tranchée selon la revendication 1, dans lequel sont réalisées des cellules à grille dans une tranchée isolées spatialement et électriquement, lesquelles comportent des structures à grille dans une tranchée supplémentaires ou des pistes conductrices en métal ou en silicium polycristallin pour assurer la connexion électrique.
